**Europäisches Patentamt**

**European Patent Office**

**Office européen des brevets**

(11) Veröffentlichungsnummer: **0 027 541**
**B1**

(12) **EUROPÄISCHE PATENTSCHRIFT**

(45) Veröffentlichungstag der Patentschrift:
20.07.83

(21) Anmeldenummer: **80105439.6**

(22) Anmeldetag: **12.09.80**

(51) Int. Cl.³: **G 06 F 5/02, H 03 K 13/25**

(54) **MOS-Schaltkreis zum Umwandeln des Codes einer Binärzahl in den der zugehörigen Dezimalzahl.**

(30) Priorität: **13.10.79 DE 2941639**

(43) Veröffentlichungstag der Anmeldung:
**29.04.81 Patentblatt 81/17**

(45) Bekanntmachung des Hinweises auf die Patenterteilung:
**20.07.83 Patentblatt 83/29**

(84) Benannte Vertragsstaaten:
**DE FR GB IT**

(56) Entgegenhaltungen:
**DE-A-2 159 901**
**DE-A-2 452 319**
**DE-A-2 625 351**
**DE-B-1 762 759**
**DE-B-2 534 736**

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT**

(72) Erfinder: **Holzmann, Dieter, Ing. grad., Unteres
Breitle 13, D-7800 Freiburg-Munzingen (DE)**
Erfinder: **Schmidtpott, Friedrich, Ing. grad., Hausener
Strasse 1, D-7801 Hartheim (DE)**

(74) Vertreter: **Stutzer, Gerhard, Dr., Deutsche ITT Industries
GmbH Patent- und Lizenzabteilung
Hans-Bunte-Strasse 19 Postfach 840, D-7800 Freiburg
(DE)**

**MOS-Schaltkreis zum Umwandeln des Codes einer Binärzahl in den der zugehörigen Dezimalzahl**

Die Erfindung betrifft einen MOS-Schaltkreis zum Umwandeln des Codes einer n-stelligen Binärzahl ($n > 3$) in den Code der zugehörigen, mindestens zweistelligen Dezimalzahl entsprechend dem Oberbegriff des Patentanspruchs.

Binär-Dezimal-Codewandler für einen vierstelligen Binärcode in einen einstelligen Dezimalcode sind beispielsweise aus der DE-B Nr. 1762759 bekannt. Dieser Codewandler benutzt pro Dezimal-Einerziffer je ein UND-Gatter mit vier Eingängen, an die die binären Stellensignale oder deren Komplement entsprechend anzulegen sind. Realisiert wird dieser Codewandler als bipolare integrierte Schaltung mittels mit ihren Kollektor-Emitter-Strecken einander parallelgeschalteten Transistoren, die auf einen als Spannungsteiler ausgebildeten gemeinsamen Emitterwiderstand arbeiten, an dessen Abgriff ein Invertertransistor angeschlossen ist. Über die Gewinnung der der Dezimal-Zehnerstelle entsprechenden Ziffer aus dem vierstelligen Binärcode ist diesem Dokument nichts zu entnehmen.

Aus der DE-A Nr. 2452319 ist ferner eine mittels MOS-Bauelementen aufgebaute Decodierschaltung für einen Eins-aus-n-Binärcode bekannt, die als Leseschaltung für entsprechende, matrixartig aufgebaute Speicher dient. Diese Anordnung enthält pro Bit die Serienschaltung von drei MOS-Transistoren, wobei dem mitteleren und einem der beiden anderen Transistoren jeweils ein weiterer Transistor parallelgeschaltet ist.

Aus den DE-A Nrn. 2625351 und 2159901 sind auch mittels MOS-Transistoren aufgebaute Decodierschaltungen bekannt, die in einer raterartigen Matrixanordnung realisiert sind, aber nicht zum Umwandeln des Codes einer n-stelligen Binärzahl ($n > 3$) in den Code der zugehörigen, mindestens zweistelligen Dezimalzahl dienen.

Für einen Codewandler, der einen n-stelligen Binärcode in einen Eins-aus-$2^n$-Code umwandelt, ist aus der DE-B Nr. 2534736 eine Realisierung mittels der sogenannten ECL-Technick bekannt, also auch mittels einer bipolaren Schaltungstechnik für integrierte Schaltungen.

Auf dem Hintergrund dieses eher allgemeinen Standes der Technik besteht die Aufgabe der Erfindung darin, einen Binär-Dezimal-Codewandler anzugeben, der in der Technik integrierter Schaltungen aus Isolierschicht-Feldeffekttransistoren (MOS-Technik) zu realisieren ist, wobei er schaltungstechnisch so auszulegen ist, dass sich eine möglichst flächensparende Anordnung auf dem Halbleiterkörper ergibt, d.h. die Anzahl der verwendeten Transistoren soll möglichst gering und deren Anordnung auf dem Halbleiterkörper soll möglichst optimal sein. Ferner soll im Rahmen dieser Aufgabe auch eine möglichst rasterartige Matrixanordnung gefunden werden.

Bei dem erfindungsgemässen MOS-Binär-Dezimal-Codewandler entsprechend dem Oberbegriff des Patentanspruchs wird diese Aufgabe gemäss dem kennzeichnenden Teil des Patentanspruchs gelöst.

Die Erfindung wird nun anhand der Figuren der Zeichnung näher erläutert.

Fig. 1 zeigt das Prinzipschaltbild eines Ausführungsbeispiels der Erfindung für die Binär-Dezimal-Codewandlung eines fünfstelligen Binärcodes in den entsprechenden Dezimalcode, und

Fig. 2 zeigt in Form einer Tabelle den zum Ausführungsbeispiel der Fig. 1 gehörenden Signalplan.

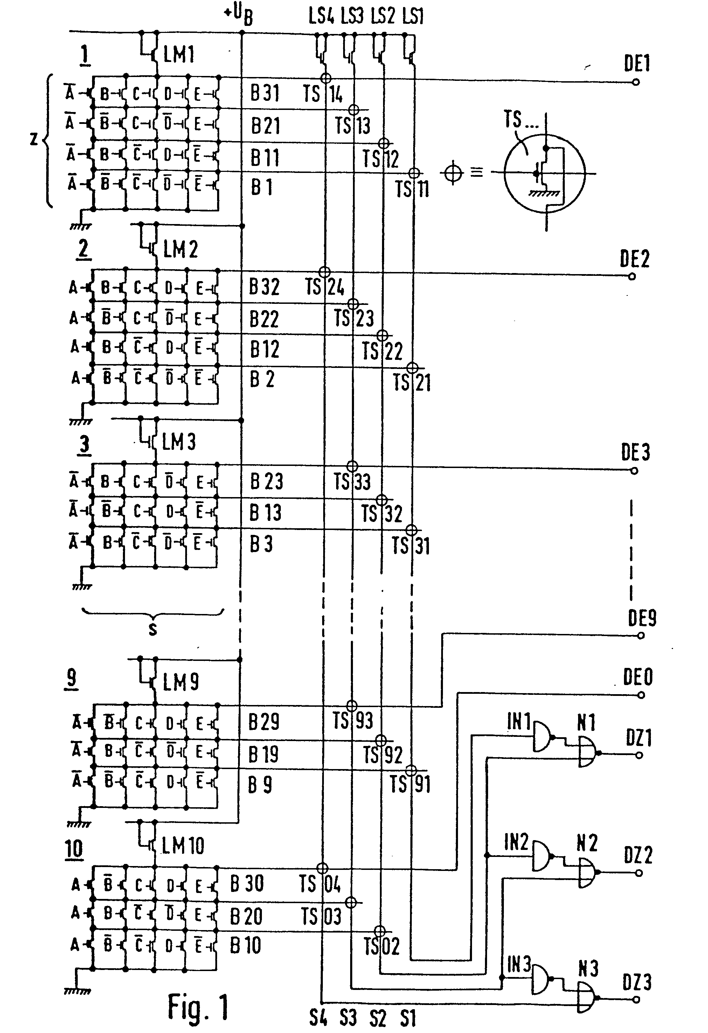

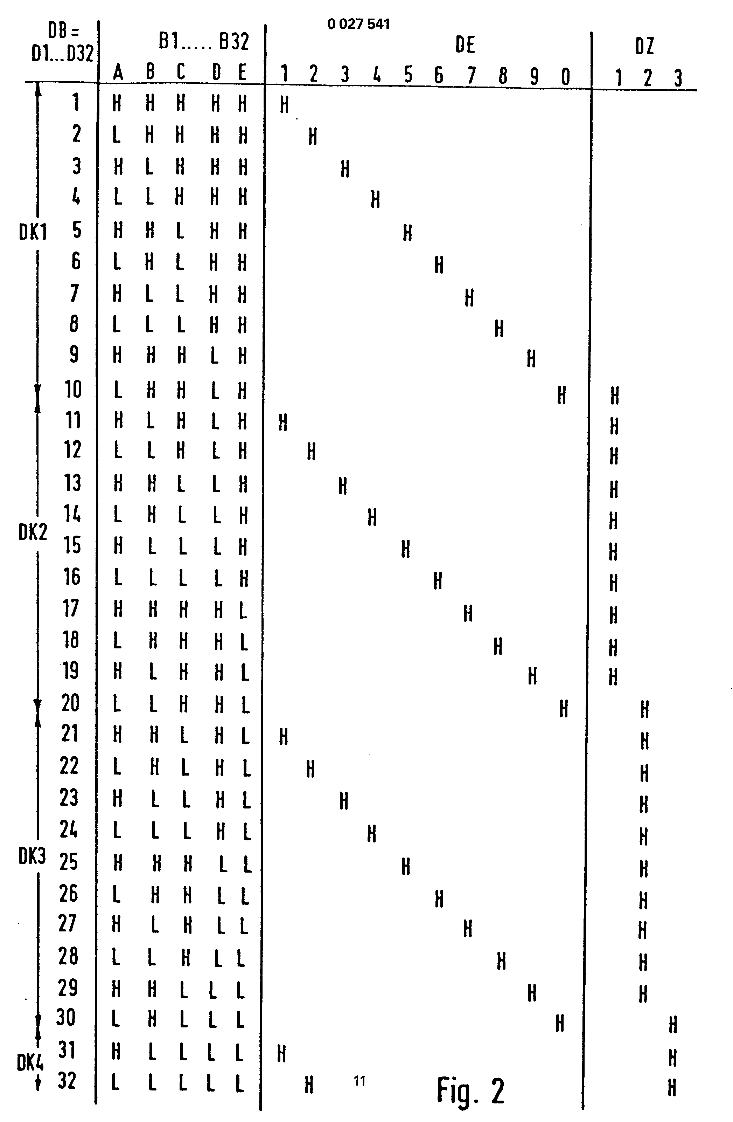

Die Fig. 1 zeigt in Form eines schematisierten Schaltbildes den schaltungstechnischen und zum Teil auch geometrischen Aufbau eines Ausführungsbeispiels der Erfindung für die Codewandlung der fünfstelligen Binärzahlen B1 ... B32 in die Dezimalzahlen D1 ... D32 des zugehörigen Dezimalzahlenbereichs DB, vgl. auch die Angaben in Fig. 2. Für das anhand der Fig. 1 und 2 geschilderte Ausführungsbeispiel ist also $n = 5$, was bedeutet, dass der Dezimalzahlenbereich 1 bis 32 umfasst wird. Die Erfindung ist selbstverständlich nicht auf fünfstellige Binärzahlen beschränkt, sondern es können auch mehr als fünfstellige Binärzahlen in den entsprechenden Code der zugehörigen Dezimalzahlen umgewandelt werden.

Wie der Tabelle der Fig. 2 zu entnehmen ist, ist es zur Erläuterung und Kennzeichnung der Erfindung erforderlich, die Dezimalzahlen in Dekaden einzuteilen und die einzelnen Stellen der Binärzahlen zu kennzeichnen. Die einzelnen Dezimaldekaden sind nach Fig. 2 so definiert, dass die erste Dezimaldekade DK1 die Dezimalzahlen D1 bis D10, die zweite Dezimaldekade DK2 die Dezimalzahlen D11 bis D20, die dritte Dezimaldekade DK3 die Dezimalzahlen D21 bis D30 und die vierte Dezimaldekade DK4 die restlichen Dezimalzahlen D31, D32 des Dezimalzahlenbereichs DB umfasst. Hierbei ist bereits eine Gesetzmässigkait von Binärzahlen zu erkennen, dass nämlich die höchste entsprechende Dezimaldekade nie zehn Zahlen umfasst. Diese Eigenschaft wird bei der Erfindung, wie die weitere Erläuterung zeigen wird, in geschickter Weise durch die Konzeption des MOS-Schaltkreises berücksichtigt.

Zu den einzelnen Stellen der Binärzahlen gehören die in Fig. 2 aufgelisteten Stellensignale A, B, C, D, E, die in bekannter Weise den dem positiveren von zwei Binärzuständen entsprechenden Wert H bzw. den dem negativeren Binärzustand entsprechenden Wert L annehmen können. Diese Zuordnung der H- bzw. der L-Zustände zu den Binärstellen ergibt sich, wenn das Ausführungsbeispiel nach Fig. 1 mittels n-Kanal-Isolierschicht-Feldeffekttransistoren realisiert wird. Bei Realisierung mittels Transistoren der anderen Leitungsart sind die Binärzustände der Fig. 2 sämtlich zu invertieren, d.h. ein H-Zustand ist durch einen L-Zustand zu ersetzen und umgekehrt.

Wie die Tabelle der Fig. 2 schliesslich noch zeigt, wird die jeweilige Dezimalzahl aus der Ziffer der Dezimal-Einerstelle DE und der Ziffer der Dezimal-

Zehnerstelle DZ bestehend aufgefasst, welche Definitionen sich ebenfalls als zweckmässig erweisen.

Das Ausführungsbeispiel der Fig. 1 zeigt in seiner linken Hälfte von den zehn vorhandenen die fünf NOR-Matrizen 1, 2, 3, 9, 10, die in dieser Reihenfolge den Dezimal-Einerziffern DE1 ... DE0 zugeordnet sind. Jede NOR-Matrix 1 ... 10 besteht aus zeilen- und spaltenweise angeordneten s mal z Transistoren, wobei die Spaltenzahl s gleich n und die Zeilenzahl z höchstens gleich der Anzahl d der im Dezimalzahlenbereich DB enthaltenen Dezimaldekaden DK ist; im Ausführungsbeispiel ist also n = 5 und d = 4 oder 3. In jeder NOR-Matrix 1 ... 10 sind die gesteuerten Strompfade der Transistoren jeder Zeile, also der Zeilentransistoren, einander parallelgeschaltet, und die der Transistoren jeder Spalte, also der Spaltentransistoren, sind miteinander in Reihe geschaltet, wobei das eine Ende jeder Reihenschaltung am Schaltungsnullpunkt und deren anderes Ende über den pro NOR-Matrix 1 ... 10 allen Spalten gemeinsamen Lasttransistor LM1 ... LM10 an der Betriebsspannung + $U_B$ liegt.

Jeder Zeile der zehn NOR-Matrizen 1 ... 10 ist eine der Binärzahlen B1 ... B32 derart zugeordnet, dass in jeder NOR-Matrix 1 ... 10 die Binärzahlen mit derselben Dezimal-Einerziffer DE1 ... DE0 zusammengefasst sind, also in der NOR-Matrix 1 die Binärzahlen B1, B11, B21, B31, in der NOR-Matrix 2 die Binärzahlen B2, B12, B22, B32, in der NOR-Matrix 3 die Binärzahlen B3, B13, B23 usw., in der NOR-Matrix 9 die Binärzahlen B9, B19, B29 und in der NOR-Matrix 10 die Binärzahlen B10, B20, B30.

Innerhalb der einzelnen NOR-Matrix 1 ... 10 ist die Zuordnung der zugehörigen Binärzahlen so vorgenommen, dass die am Schaltungsnullpunkt liegende Zeile zur Binärzahl B1 ... B10 aus der niedersten Dezimaldekade DK1 gehört, dass die in Richtung auf den gemeinsamen Lasttransistor LM1 ... LM10 nächsthöhere Zeile zur Binärzahl B11 ... B20 aus der nächsthöheren Dezimaldekade DK2 gehört usw. bis zur am Lasttransistor LM1 ... LM10 liegenden Zeile, die zur Binärzahl B31, B32 aus der höchsten Dezimaldekade DK4 gehört. Für fünfstellige Binärzahlen nach dem Ausführungsbeispiel der Fig. 1 enthalten also die NOR-Matrizen 1, 2 jeweils vier Zeilen und die NOR-Matrizen 3 ... 10 drei Zeilen. Bei sechsstelligen Binärzahlen, also dem entsprechenden Dezimalzahlenbereich DB von D1 bis D64, müssten entsprechend die ersten vier NOR-Matrizen siebenzeilig und die restlichen sechs NOR-Matrizen sechszeilig sein. Bei siebenstelligen Binärzahlen hätten die ersten acht NOR-Matrizen dreizehn und die restlichen beiden NOR-Matrizen zwölf Zeilen.

Die Stellensignale A ... E einer einzelnen Binärzahl bzw. die Komplemente $\overline{A}$, $\overline{B}$, $\overline{C}$, $\overline{D}$, $\overline{E}$ der Stellensignale A ... E sind an die zu dieser Binärzahl gehörenden Zeilentransistoren so anzulegen, dass bei Auftreten des entsprechenden Codes diese Transistoren sämtlich gesperrt werden.

Im Ausführungsbeispiel der Fig. 1 sind die zu den einzelnen Zeilen gehörenden Binärzahlen angegeben und ausserdem die zu diesen Zeilen gehörenden Stellensignale in ihrer direkten bzw. komplementierten, also invertierten, Form. So zeigt beispielsweise in der NOR-Matrix 1 die Zeile B1, dass sämtliche Stellensignale in invertierter Form, also die Signale $\overline{A}$ ... $\overline{E}$, anzulegen sind. Unter Berücksichtigung der in Fig. 2 für die Binärzahl B1 angegebenen Stellensignale, die alle einen H-Zustand aufweisen, ergibt sich somit, dass bei Anliegen dieses Signals an der mit B1 bezeichneten Zeile der NOR-Matrix 1 alle Transistoren dieser Zeile gesperrt sind, da n-Kanal-Transistoren bei Ansteuerung mit einem L-Zustand sperren. Die gleichen Überlegungen gelten für alle anderen Zeilen der einzelnen NOR-Gatter.

Durch die erwähnte Zuordnung der Zeilen der jeweiligen NOR-Matrix zu den Binärzahlen derselben Dezimal-Einerziffer, wobei die Zeilen, ausgehend vom Schaltungsnullpunkt, so übereinander angeordnet sind, dass in jeder nächsthöheren Zeile die zur nächsthöheren Dezimaldekade gehörende Binärzahl anliegt, ergeben sich die für die Erfindung wesentliche Funktion und der Vorteil, dass am Ausgang der jeweiligen Zeile, der mit dem dem Schaltungsnullpunkt abgewandten Ende des gesteuerten Strompfades der entsprechenden Zeilentransistoren identisch ist, nur und nur dann ein H-Zustand auftritt, wenn die zugehörige Binärzahl an den Steuerelektroden der zugehörigen Zeilentransistoren anliegt. Bei nichtanliegendem Binärzahlencode sind nämlich alle Transistoren der jeweiligen NOR-Matrix leitend, so dass an den zugehörigen Zeilenausgängen ein L-Zustand vorhanden ist. Tritt nun im anliegenden Code der Code einer entsprechenden Zeile, also z.B. der zur Binärzahl B1 gehörende Code auf, so werden die Transistoren dieser Zeile gesperrt und wegen der leitenden anderen Transistoren dieser NOR-Matrix, deren Längswiderstand im Vergleich zum Widerstand des Lasttransistors LM1 klein ist, tritt am Ausgang dieser Zeile der erwähnte H-Zustand auf. Dies gilt in gleicher Weise, wenn beispielsweise in der NOR-Matrix 1 die Transistoren der zur Binärzahl B21 gehörenden Zeile, also der vom Schaltungsnullpunkt aus gesehen dritten Zeile, in den Sperrzustand gesteuert werden, da in diesem Falle die Längswiderstände der leitenden Transistoren der anderen Zeilen vernachlässigbar sind und somit am Ausgang der gesperrten Zeile wiederum ein H-Zustand auftritt.

Die an den Zeilenausgängen der NOR-Matrizen 1 ... 10 nach Fig. 1 entstehenden Signale werden nun im Vielfach-NOR-Gatter 11 weiterverarbeitet. Es hat p Spalten S1 ... S4, wobei p gleich der Anzahl d der im Dezimalzahlenbereich DB der Binärzahlen B1 ... B32 enthaltenen Dezimalzahlenbereich DB der Binärzahlen B1 ... B32 enthaltenen Dezimaldekaden DK1 ... DK4 ist, d.h. die Spaltenzahl p ist auch gleich der grösseren der beiden möglichen Zeilenzahlen z der NOR-Matrizen 1 ... 10.

Den einzelnen Spalten S1 ... S4 ist eine Dezimaldekade DK1 ... DK4 gleichsinnig zugeordnet, d.h. der Spalte S1 die Dezimaldekade DK1 usw. Jede Spalte besteht aus mit ihrem gesteuerten Strompfad einander parallelgeschalteten und zwischen dem gemeinsamen Lasttransistor LS1, LS2, LS3, LS4 und dem Schaltungsnullpunkt liegenden Transistoren TS ... Sie sind in der folgenden Art und Weise mit den Zeilenausgängen der NOR-Matrizen 1 ... 10 verbunden. Am Ausgang der den ersten neun Binärzahlen B1 ... B9 zugeordneten Zeilen aus den ersten neun NOR-Matrizen 1 ... 9 liegt die Steuerelektrode der Transistoren TS11 ... T91 der ersten Spalte S1. Am Ausgang der den folgenden zehn Binärzahlen B10 ... B19 zugeordneten Zeilen aller zehn NOR-Matrizen 1 ... 10 liegt die Steuerelektrode der Transistoren TS02 ... TS92 der zweiten Spalte S2. Entsprechendes gilt für die Transistoren TS03 ... TS93 der dritten Spalte und die Transistoren TS04, TS14, TS24 der vierten Spalte S4.

Im einzelnen liegt also beispielsweise die Steuerelektrode des Transistors TS11 am Ausgang der zur Binärzahl B1 gehörenden Zeile der NOR-Matrix 1, während beispielsweise die Steuerelektrode des Transistors TS02 am Ausgang der zur Binärzahl B10 gehörenden Zeile der NOR-Matrix 10 oder die Steuerelektrode des Transistors TS04 am Ausgang der zur Binärzahl B30 gehörenden Zeile der NOR-Matrix 10 oder die Steuerelektrode des Transistors TS24 am Ausgang der zur Binärzahl B32 gehörenden Zeile der NOR-Matrix 2 liegt.

Die Ausgänge der Spalten S1 ... S4 des Vielfach-NOR-Gatters 11 sind ferner zur Gewinnung des Signals bezüglich der Dezimal-Zehnerziffern DZ1, DZ2, DZ3 wie folgt geschaltet. Der Ausgang der ersten Spalte S1 liegt über den ersten Inverter IN1 am ersten Eingang des ersten Dekaden-NOR-Gatters N1, an dessen zweitem Eingang der Ausgang der zweiten Spalte S2 liegt. Dieser Ausgang liegt ferner über den zweiten Inverter IN2 am ersten Eingang des zweiten Dekaden-NOR-Gatters N2, an dessen zweitem Eingang der Ausgang der dritten Spalte S3 liegt. Dieser wiederum liegt über den dritten Inverter IN3 am ersten Eingang des dritten Dekaden-NOR-Gatters N3, an dessen zweitem Eingang der Ausgang der vierten Spalte S4 liegt. Diese Art der Verknüpfung der einzelnen Spaltenausgänge, die identisch mit dem Verbindungspunkt zwischen den Transistoren TS ... der betreffenden Spalte und dem zugehörigen Lasttransistor LS1 ... LS4 ist, wird bei den erwähnten Anordnungen mit einer von n = 5 abweichenden Stellenzahl der Binärzahl in entsprechender Weise weitergeführt. Dadurch ergeben sich bei Anordnung für n ≧ 7 auch die Dezimal-Hunderterziffern.

Der Code für die Dezimal-Einerstellen DE0 ... DE9 ist am Ausgang der der höchsten Dezimaldekade DK4 bzw. DK3 zugeordneten Zeilen der NOR-Matrizen 1 ... 10 und der Code für die Dezimal-Zehnerstellen DZ1 ... DZ3 am Ausgang der Dekaden-NOR-Gatter N1 ... N3 abzunehmen. Am Verbindungspunkt des jeweiligen Lastwiderstandes LM1 ... LM10 mit den entsprechenden Transistoren der obersten Zeile der NOR-Matrizen 1 ... 10 entsteht also das Signal für die Dezimal-Einerstellen, am Lastwiderstand LM1 der NOR-Matrix 1 also das Signal für die Dezimal-Einerziffer DE1, am Lastwiderstand LM2 der NOR-Matrix 2 das Signal für die Dezimal-Einerstelle DE2 usw. bis zum Lastwiderstand LM10 der NOR-Matrix 10 mit dem Signal für die Dezimal-Einerstelle DE0.

Die Vorteile der Erfindung ergeben sich aus der Lösung der eingangs erwähnten Aufgabe und liegen besonders darin, dass sich eine möglichst flächensparende, optimale Anordnung der einzelnen MOS-Transistoren auf dem Halbleiterkörper des Schaltkreises ergibt und somit die Anzahl der verwendeten Transistoren möglichst gering ist. Ausserdem ergibt sich eine rasterartige Matrixanordnung, die ebenfalls zur optimalen Anordnung beiträgt.

## Patentanspruch

MOS-Schaltkreis zum Umwandeln des Codes einer n-stelligen Binärzahl (n > 3) in den Code der zugehörigen, mindestens zweistelligen Dezimalzahl mittels MOS-Gattern, die von den jeweiligen, den Binärstellen der Binärzahl entsprechenden binären Stellesignalen oder deren Komplement parallel angesteuert sind, gekennzeichnet durch folgende Merkmale:
— für die zehn Einerziffern (DE1 ... DE0) der Dezimalzahlen (D1 ... D32) ist je eine NOR-Matrix (1 ... 10) mit zeilen- und spaltenweise angeordneten s mal z Transistoren vorgesehen (s = Anzahl der Spalten, z = Anzahl der Zeilen),
— in jeder NOR-Matrix (1 ... 10) sind die gesteuerten Strompfade der Transistoren jeder Zeile, also der Zeilentransistoren, einander parallelgeschaltet und die gesteuerten Strompfade der Transistoren jeder Spalte, also der Spaltentransistoren, sind miteinander in Reihe geschaltet, wobei das eine Ende jeder Reihenschaltung am Schaltungsnullpunkt und deren anderes Ende über einen pro NOR-Matrix (1 ... 10) allen Spalten gemeinsamen Lasttransistor (LM1 ... LM10) an der Betriebsspannung ($+U_B$) liegt,
— die Spaltenanzahl s der jeweiligen NOR-Matrix (1 ... 10) ist gleich n,
— die Zeilenanzahl z ist höchstens gleich der Anzahl (d) der in dem durch die n-stelligen Binärzahlen (B1 ... B32) repräsentierten Dezimalzahlenbereich (DB) enthaltenen Dezimaldekaden (DK),
— jeder Zeile der zehn NOR-Matrizen (1 ... 10) ist eine der Binärzahlen (B1 ... B32) derart zugeordnet, dass in jeder NOR-Matrix die Binärzahlen (B1, B11, B21, B31 usw.) mit derselben Dezimal-Einerziffer (DE1 ... DE0) zusammengefasst sind, und zwar derart, dass die am Schaltungsnullpunkt liegende Zeile zur Binärzahl (B1 ... B10) mit dieser Dezimal-Einerziffer aus der niedersten Dezimaldekade (DK1) gehört, dass die in Richtung auf den gemeinsamen Lasttransistor (LM1) nächsthöhere Zeile zur Binärzahl (B11 ... B20) mit derselben Dezimal-Einerziffer aus der nächsthöheren Dezimaldekade (DK2) gehört usw. bis zur am Lasttransistor (LM1) liegenden Zeile, die zur Binärzahl (B31, B32) mit derselben Dezimal-Einerziffer aus der höchsten Dezimaldekade (DK4) gehört,

— an die Steuerelektroden der Zeilentransistoren einer zu einer einzelnen Binärzahl (B1 ... B32) gehörenden Zeile sind die Stellensignale (A, B, C, D, E) dieser Binärzahl bzw. deren Komplement ($\overline{A}$, $\overline{B}$, $\overline{C}$, $\overline{D}$, $\overline{E}$) derart anzulegen, dass dadurch alle Zeilentransistoren dieser Zeile gesperrt werden,

— es ist ferner ein Vielfach-NOR-Gatter (11) mit p Spalten (S1 ... S4) vorhanden, wobei p gleich der Anzahl (d) der im Dezimalzahlenbereich (DB) der Binärzahlen (B1 ... B32) enthaltenen Dezimaldekaden (DK1 ... DK4) ist,

— jeder Spalte (S1 ... S4) des Vielfach-NOR-Gatters ist eine Dezimaldekade (DK1 ... DK4) gleichsinnig zugeordnet (S1 ≙ DK1 usw.), und diese Spalte besteht aus mit ihrem gesteuerten Strompfad einander parallelgeschalteten, zwischen einem gemeinsamen Lasttransistor (LS1 ... LS4) und dem Schaltungsnullpunkt liegenden Transistoren (TS ...),

— am Ausgang der den ersten neun Binärzahlen (B1 ... B9) zugeordneten Zeilen der ersten neun NOR-Matrizen (1 ... 9) liegt die Steuerelektrode jeweils eines Transistors (TS11 ... TS91) der ersten Spalte (S1) des Vielfach-NOR-Gatters,

— am Ausgang der den folgenden zehn Binärzahlen (B10 ... B19) zugeordneten Zeilen der zehn NOR-Matrizen (1 ... 10) liegt die Steuerelektrode jeweils eines Transistors (TS02 ... TS92) der zweiten Spalte (S2) des Vielfach-NOR-Gatters,

— am Ausgang der den zehn folgenden Binärzahlen (B20 ... B29) zugeordneten Zeilen der zehn NOR-Matrizen (1 ... 10) liegt die Steuerelektrode jeweils eines Transistors (TS03 ... TS93) der dritten Spalte (S3) des Vielfach-NOR-Gatters usw.,

— am Ausgang der den restlichen Binärzahlen (B30 ... B32) zugeordneten Zeilen der zehn NOR-Matrizen (1 ... 10) liegt die Steuerelektrode jeweils eines Transistors (TS04 ... TS24) der letzten Spalte (S4) des Vielfach-NOR-Gatters,

— der Ausgang der ersten Spalte (S1) des Vielfach-NOR-Gatters liegt über einen ersten Inverter (IN1) am ersten Eingang eines ersten Dekaden-NOR-Gatters (N1), an dessen zweitem Eingang der Ausgang der zweiten Spalte (S2) des Vielfach-NOR-Gatters liegt,

— dieser Ausgang liegt über einen zweiten Inverter (IN2) am ersten Eingang eines zweiten Dekaden-NOR-Gatters (N2), an dessen zweitem Eingang der Ausgang der dritten Spalte (S3) des Vielfach-NOR-Gatters liegt,

— dieser Ausgang liegt über einen dritten Inverter (IN3) am ersten Eingang eines dritten Dekaden-NOR-Gatters (N3), an dessen zweitem Eingang der Ausgang der vierten Spalte (S4) des Vielfach-NOR-Gatters liegt usw. bis zur höchsten Dezimaldekade,

— am Ausgang der der höchsten Dezimaldekade (DK4 bzw. DK3) zugeordneten Zeilen der NOR-Matrizen (1 ... 10) ist das Signal für die Ziffern (DE0 ... DE9) der Dezimal-Einerstelle (DE) und am Ausgang der Dekaden-NOR-Gatter (N1 ... N3) das Signal für die Ziffern (DZ1 ... DZ3) der Dezimal-Zehnerstelle (DZ) abzunehmen, und

— alle verwendeten Transistoren sind von derselben Leitungsart (n-Kanal bzw. p-Kanal) und von demselben Steuerungstyp (Verarmungs- bzw. Anreicherungstyp).

## Claim

MOS switching circuit for converting the code of an n-position binary number (n > 3) into the code of the associated, at least two-place decimal number with the aid of MOS-gates which are controlled by the respective binary position signals or the complement thereof, corresponding to the binary positions of the binary number, characterized by the following features:

— for the ten digits in the units place (DE1 ... DE0) of the decimal numbers (D1 ... D32) there is provided each time one NOR-matrix (1 ... 10) with s times z transistors arranged in a row- and column-wise manner (s = number of columns, z = number of rows),

— in each NOR-matrix (1 ... 10) the controlled current paths of the transistors of each row, hence the row transistors, are arranged in parallel with one another, and the controlled current paths of the transistors of each column, hence the column transistors, are arranged in series with one another, with the one end of each series arrangement being applied to the zero point of the circuit, and with the other end thereof, via a load transistor (LM1 ... LM10) which is common to all columns per NOR-matrix (1 ... 10), being applied to the supply voltage ($+U_B$),

— the number of columns s of the respective NOR-matrix (1 ... 10) equals n,

— the number of rows z is in the utmost equal to the number (d) of the decimal decades (DK) contained in the decimal number range (DB) as represented by the n-position binary numbers (B1 ... B32),

— to each row of the ten NOR-matrices (1 ... 10) there is assigned one of the binary numbers (B1 ... B32) in such a way that in each NOR-matrix the binary numbers (B1, B11, B21, B31, etc.) are combined with the same decimal units digit (DE1 ... DE0), i.e. in such a way that the row as applied to the zero point of the circuit belongs to the binary number (B1 ... B10) with this decimal units digit from the lowest decimal decade (DK1), that the row which is the next higher one in direction towards the common load transistor (LM1) belongs to the binary number (B11 ... B20) with the same decimal units digit from the next higher decimal decade (DK2), and so on up to the row applied to the load transistor (LM1) which belongs to the binary number (B31, B32) with the same decimal units digit from the highest decimal decade (DK4),

— to the gate electrodes of the row transistors in a row belonging to one individual binary number (B1 ... B32) there are to be applied the position signals (A, B, C, D, E) of this binary number or else the complement thereof ($\overline{A}$, $\overline{B}$, $\overline{C}$, $\overline{D}$, $\overline{E}$) so that in this way all row transistors of this particular row are switched to the non-conducting state,

— moreover, there is provided a multiple-NOR-gate (11) having p columns (S1 ... S4), with p being equal to the number (d) of the decimal decades (DK1 ... DK4) as contained in the decimal number range (DB) of the binary numbers (B1 ... B32),

— to each column (S1 ... S4) there is equidirectionally assigned one decimal decade (DK1 ... DK4) (S1 ≙ DK1, etc.), and this particular column consists of transistors (TS ...) arranged parallel in relation to one another with their controlled current paths, arranged between one common load transistor (LS1 ... LS4) and the zero point of the circuit,

— the gate electrode of respectively one transistor (TS11 ... TS91) of the first column (S1) is applied to the output of the rows of the first nine NOR-matrices (1 ... 9) associated with the first nine binary numbers (B1 ... B9),

— the gate electrode of respectively one transistor (TS02 ... TS92) of the second column (S2) is applied to the output of the rows of the ten NOR-matrices (1 ... 10) as associated with the following ten binary numbers (B10 ... B19),

— the gate electrode of respectively one transistor (TS03 ... TS93) of the third column (S3) is applied to the output of the rows of the ten NOR-matrices (1 ... 10) associated with the ten following binary numbers (B20 ... B29), etc.,

— the gate electrode of respectively one transistor (TS04 ... TS24) of the last column (S4) is applied to the output of the rows of the ten NOR-matrices (1 ... 10) associated with the remaining binary numbers (B30 ... B32),

— the output of the first column (S1) is applied via a first inverter (IN1) to the first input of a first decade-NOR-gate (N1) to the second input of which there is applied the output of the second column (S2),

— this output is applied via a second inverter (IN2) to the first input of a second decade-NOR-gate (N2), to the second input of which there is applied the output of the third column (S3),

— this output is applied via a third inverter (IN3) to the first input of a third decade-NOR-gate (N3), to the second input of which there is applied the output of the fourth column (S4), etc., up to reaching the highest decimal decade,

— at the output of the rows of the NOR-matrices (1 ... 10) associated with the highest decimal decade (DK4 or DK3) there is to be taken off the signal for the digits (DE0 ... DE9) of the decimal units position (DE), and at the output of the decade-NOR-gate (N1 ... N3) there is to be taken off the signal for the digits (DZ1 ... DZ3) of the decimal-tens position (DZ), and

— all of the employed transistors are of the same conductivity type (n-channel or p-channel) as well as of the same control type (depletion or enhancement type).

## Revendication

Circuit MOS pour transformer le code d'un nombre binaire à n emplacements binaires (n > 3) en code du nombre décimal correspondant ayant au moins deux emplacements décimaux, au moyen de portes MOS qui sont commandées en parallèle par les signaux respectifs d'emplacements binaires qui correspondent aux emplacements binaires du nombre binaire, ou par leur complément, ce circuit étant caractérisé par la combinaison de caractéristiques ci-après:

— pour les dix chiffres des unités (DE1 ... DE0) des nombres décimaux (D1 à D32), il est prévu, à chaque fois, une matrice NOR (1 ... 10) avec z fois s transistors agencés en lignes et colonnes (z = nombre de lignes, s = nombre de colonnes);

— dans chaque matrice NOR (1 ... 10) les trajets de courant des transistors de chaque ligne, donc des transistors de lignes, sont branchés en parallèle les uns des autres, et les trajets de courant commandés des transistors de chaque colonne, donc des transistors de colonnes, sont branchés en série les uns avec les autres, chaque groupement série ayant sa première extrémité appliquée au point zéro du circuit et son autre extrémité appliquée à la tension de fonctionnement ($+U_B$), cela via un transistor de charge (LM1 ... LM10) commun à toutes les colonnes, un tel transistor de charge étant prévu pour chaque matrice NOR (1 ... 10);

— le nombre s des colonnes de chaque matrice NOR (1 ... 10) est égal à n;

— le nombre z des lignes est au plus égal au nombre (d) des décades décimales (DK) contenues dans la plage (DB) de nombres décimaux représentés par les nombres binaires (B1 ... B32) à n emplacements binaires;

— à chaque ligne des dix matrices NOR (1 ... 10) est affecté l'un des nombres binaires (B1 ... B32) de façon telle que, dans chaque matrice NOR, soient regroupés les nombres binaires (B1, B11, B21, B31, etc.) ayant le même chiffre décimal des unités (DE1 ... DE0), et cela de façon telle que la ligne appliquée au point zéro du circuit soit relative au nombre binaire (B1 ... B10) ayant le chiffre décimal des unités de la décade décimale la plus basse (DK1), et que la ligne immédiatement supérieure (supérieure en considérant la direction vers le transistor (LM1) de charge commun) soit relative au nombre binaire (B11 ... B20) avec le même chiffre décimal des unités dans la décade décimale immédiatement supérieure (DK2), etc., jusqu'à la dernière ligne connectée au transistor de charge (LM1), laquelle est relative au nombre binaire (B31, B32) ayant le même chiffre décimal des unités dans la décade décimale la plus haute (DK4);

— aux électrodes de commande des transistors d'une ligne relative à un nombre binaire individuel (B1 ... B32), les signaux d'emplacements numériques (A, B, C, D, E) de ce nombre binaire, ou leurs compléments ($\overline{A}$, $\overline{B}$, $\overline{C}$, $\overline{D}$, $\overline{E}$), sont applicables de façon que tous les transistors de ligne relatifs à cette ligne s'en trouvent bloqués;

— il y a en outre une porte NOR multiple (11) avec p colonnes (S1 ... S4), p étant égal au nombre (d) des décades décimales (DK1 ... DK4) contenues dans la plage (DB) de nombres décimaux des nombres binaires (B1 ... B32);

— à chaque colonne (S1 ... S4) de la porte NOR multiple est affectée une décade décimale (DK1 ... DK4), cette affectation étant dans le même sens (S1 ≙ DK1, etc.) et cette colonne est constituée de transistors (TS ...) qui, par leur trajet de courant commandé, sont branchés en parallèle, et qui se trouvent entre un transistor de charge commun (LS1 ... LS4) et le point zéro du circuit;

— chaque sortie des lignes qui sont affectées aux neuf premiers nombres binaires (B1 ... B9) et qui appartiennent aux neuf premières matrices NOR (1 ... 9), est appliquée à l'électrode de commande d'un transistor (TS11 ... TS91) de la première colonne (S1) de la porte NOR multiple;

— chaque sortie des lignes qui appartiennent aux dix matrices NOR (1 ... 10) et qui sont affectées aux dix nombres binaires suivants (B10 ... B19) est appliquée à l'électrode de commande d'un transistor (TS02 ... TS92) de la deuxième colonne (S2) de la porte NOR multiple;

— chaque sortie des lignes qui appartiennent aux dix matrices NOR (1 ... 10) et qui sont affectées aux dix nombres binaires suivants (B20 ... B29) est appliquée à l'électrode de commande d'un transistor (TS03 ... TS93) de la troisième colonne (S3) de la porte NOR multiple, etc.;

— chaque sortie des lignes qui appartiennent aux dix matrices NOR (1 ... 10) et qui sont affectées aux nombres binaires restants (B30 ... B32) est appliquée à l'électrode de commande d'un transistor (TS04 ... TS24) de la dernière colonne (S4) de la porte NOR multiple;

— la sortie de la première colonne (S1) de la porte NOR multiple est appliquée, *via* un premier inverseur (IN1) à la première entrée d'une première porte NOR (N1) de décade, à la deuxième entrée de laquelle est appliquée la sortie de la deuxième colonne (S2) de la porte NOR multiple;

— par l'intermédiaire d'un deuxième inverseur (IN2), cette sortie est appliquée à la première entrée d'une deuxième porte (N2) NOR de décade, à la deuxième entrée de laquelle est appliquée la sortie de la troisième colonne (S3) de la porte NOR multiple;

— par l'intermédiaire d'un troisième inverseur (IN3), cette sortie est appliquée à la première entrée d'une troisième porte NOR (N3) de décade, à la deuxième entrée de laquelle est appliquée la quatrième colonne (S4) de la porte NOR multiple, etc., jusqu'à la décade décimale la plus haute;

— à la sortie de celles des lignes des matrices NOR (1 ... 10) qui sont les lignes affectées à la plus haute décade décimale (DK4 ou DK3 selon le cas), on prélève le signal pour les chiffres (DE0 ... DE9) de l'emplacement décimal des unités (DE) et, à la sortie des portes NOR (N1 ... N3) de décade, le signal pour les chiffres (DZ1 ... DZ3) de la position décimale des dizaines (DZ), et

— tous les transistors utilisés sont du même type de conduction (canal n ou canal p) et du même type de commande (appauvrissement ou enrichissement).

Fig. 1

0 027 541

| DK | DB = D1...D32 | A | B | C | D | E | 1 | 2 | 3 | 4 | 5 | 6 | 7 | 8 | 9 | 0 | 1 | 2 | 3 |
|---|---|---|---|---|---|---|---|---|---|---|---|---|---|---|---|---|---|---|---|
| DK1 | 1 | H | H | H | H | H | H | | | | | | | | | | | | |
| | 2 | L | H | H | H | H | | H | | | | | | | | | | | |
| | 3 | H | L | H | H | H | | | H | | | | | | | | | | |
| | 4 | L | L | H | H | H | | | | H | | | | | | | | | |
| | 5 | H | H | L | H | H | | | | | H | | | | | | | | |
| | 6 | L | H | L | H | H | | | | | | H | | | | | | | |
| | 7 | H | L | L | H | H | | | | | | | H | | | | | | |
| | 8 | L | L | L | H | H | | | | | | | | H | | | | | |
| | 9 | H | H | H | L | H | | | | | | | | | H | | | | |
| | 10 | L | H | H | L | H | | | | | | | | | | H | H | | |
| DK2 | 11 | H | L | H | L | H | H | | | | | | | | | | H | | |
| | 12 | L | L | H | L | H | | H | | | | | | | | | H | | |
| | 13 | H | H | L | L | H | | | H | | | | | | | | H | | |
| | 14 | L | H | L | L | H | | | | H | | | | | | | H | | |
| | 15 | H | L | L | L | H | | | | | H | | | | | | H | | |
| | 16 | L | L | L | L | H | | | | | | H | | | | | H | | |
| | 17 | H | H | H | H | L | | | | | | | H | | | | H | | |
| | 18 | L | H | H | H | L | | | | | | | | H | | | H | | |
| | 19 | H | L | H | H | L | | | | | | | | | H | | H | | |
| | 20 | L | L | H | H | L | | | | | | | | | | H | | H | |
| DK3 | 21 | H | H | L | H | L | H | | | | | | | | | | | H | |
| | 22 | L | H | L | H | L | | H | | | | | | | | | | H | |
| | 23 | H | L | L | H | L | | | H | | | | | | | | | H | |
| | 24 | L | L | L | H | L | | | | H | | | | | | | | H | |
| | 25 | H | H | H | L | L | | | | | H | | | | | | | H | |
| | 26 | L | H | H | L | L | | | | | | H | | | | | | H | |
| | 27 | H | L | H | L | L | | | | | | | H | | | | | H | |
| | 28 | L | L | H | L | L | | | | | | | | H | | | | H | |
| | 29 | H | H | L | L | L | | | | | | | | | H | | | H | |
| | 30 | L | H | L | L | L | | | | | | | | | | H | | | H |
| DK4 | 31 | H | L | L | L | L | H | | | | | | | | | | | | H |
| | 32 | L | L | L | L | L | | H | | | | | | | | | | | H |

Fig. 2